# EUROPEAN PATENT APPLICATION

(11) **EP 4 411 814 A1**
(43) Date of publication of application: **07.08.2024**
(21) Application number: 24150220.2
(22) Date of filing: 03.01.2024
(51) Int. Cl.: H01L 23/495, H01L 23/00

(54) **METHOD OF MANUFACTURING SEMICONDUCTOR DEVICES, CORRESPONDING RIBBON, APPARATUS AND DEVICE**

(30) Priority: 20.01.2023 IT 202300000849
(71) Applicant: STMicroelectronics International N.V., 1228 Plan-les-Ouates, Geneva (CH)
(72) Inventor: MAZZOLA, Mauro, I-24040 Calvenzano (Bergamo) (IT); MARCHISI, Fabio, I-20068 Peschiera Borromeo (Milano) (IT)
(74) Representative: Bosotti, Luciano

(57) **Abstract**

A semiconductor die (14) is arranged at a die mounting location (12A) of a substrate (12). The substrate (12) comprises an array of electrically conductive leads (12B) at the periphery of the substrate (12) .

Electrical coupling is provided between the semiconductor die (14) and selected ones of the electrically conductive leads (12B) in the array of electrically conductive leads (12B) via electrically conductive ribbons (20) having a body portion (200) having a first width (W1) as well as first and second end portions (201) bonded to the semiconductor die (14) and to the electrically conductive leads (12B), respectively.

At least one of the first and second end portions (201) of the electrically conductive ribbons (20) comprises a tapered portion having a second width (W2) smaller than the first width (W1) of the body portion (200) .

## Description

### Technical field

The description relates to manufacturing semiconductor devices.

Solutions as described herein can be applied to power (integrated circuit) semiconductor devices such as power QFN packages, for automotive products, for instance.

### Background

In power integrated circuit semiconductor devices, the current transferred from the high-power section to the output pads of the device can be significant. Clips, ribbons or multiple wires can be used for that purpose in the place of single wires.

Clips are currently stamped from flat material. Pins with the purpose of centering the clip on the leadframe can also be created in the clip material by punching. Recesses are created at corresponding leadframe positions to house the clip pins for centering purposes.

In small packages (power Quad-Flat No Leads - QFNs - for instance) and/or if several channels are desired to be provided in the final package, more pads are needed and the dimensions for recesses on leadframe and clips may become relatively small.

The relatively small dimensions may lead to difficulties in manufacturing and handling the clips.

Another approach is based on bonding using multiple wires; such a method involves wedge-bonding a plurality of wires and may thus be undesirably time consuming.

Yet another approach is based on the use of electrically conductive ribbons to provide electrical coupling between the power section of a (integrated circuit, IC) semiconductor device and the outer pads.

These ribbons are bonded via ultrasonic wedge-bonding and such a bonding method may severely damage the (relatively small) outer pads.

Differences (as well as advantages/disadvantages) between the mentioned coupling techniques are discussed, for instance, in the article "The Importance of Interconnection Technologies' Reliability of Power Electronic Packages" by S. Jacques.

Document WO 2014169209 A1 discloses a packaged multi-output converter comprising a leadframe with a chip pad as ground terminal and a plurality of leads including the electrical input terminal. The converter comprises a first FET chip with its source terminal affixed to the leadframe and on its opposite surface a first drain terminal positioned adjacent to a second drain terminal. The drain terminals are connected respectively by a first and a second metal clip to a first and second output lead. The converter comprises a second FET chip, positioned vertically over the first drain terminal, with its source terminal attached onto the first clip. The converter comprises a third FET chip, positioned vertically over the second drain terminal, with its source terminal attached onto the second clip. The drain terminals of the second and third chips are attached onto a third metal clip connected to the input lead.

Document EP 4002447 A1 discloses a contact clip for a semiconductor device package including a first section configured to be mounted to a bond pad on a die. The contact clip further includes a second section configured to be mounted to a terminal post of a semiconductor device package. An intermediate section of the contact clip extends between the first section and the second section in a first lateral direction. The first section is bent downwards from the intermediate section and has a dimension in the first lateral direction which narrows in the downward direction to end in a contact area surface of a reduced first lateral dimension

Document EP 2916348 A1 discloses a semiconductor module provided for shortening a manufacturing tact time and reduce manufacturing costs and for ensuring reliability of a bonding portion. The semiconductor module includes a substrate formed of a metal, an insulating layer formed on the substrate, a plurality of wiring patterns formed on the insulating layer, a bare-chip transistor mounted on one wiring pattern via a solder, and copper connectors that connects electrodes formed on the bear-chip transistor and other wiring patterns via a solder. The copper connectors has a bridge shape, has a width-reduced portion formed in the vicinity of the bonding face to the electrodes, and has a stress-reducing portion formed on the bonding face bonded to the electrode.

The documents cited above disclose devices having electrical coupling provided via electrically conductive clips.

### Object and summary

Solutions as described herein aim at addressing the issues discussed in the foregoing.

Such an object can be achieved via a method having the features set forth in the claims that follow.

One or more embodiments relate to a ribbon for use in a method as described herein.

One or more embodiments relate to an apparatus for use in manufacturing ribbons as described herein.

One or more embodiments relate to a corresponding (integrated circuit) semiconductor device.

The claims are an integral part of the technical teaching provided in respect of the embodiments.

In solutions as described herein electrical coupling between the power section of a semiconductor device and the outer pads is provided via ribbon bonding.

In solutions as described herein a ribbon is provided with a reduced bonding area to reduce the mechanical stress applied during wedge-bonding.

Solutions as described herein may involve dispensing a conductive material, such as solder paste or glue, at ends of the ribbon in order to increase conductivity of the electrical coupling via the ribbon.

Solutions as described herein may involve a (slight) modification of the ultrasonic wedge-bonding apparatus.

Solutions as described herein contemplate providing a leadframe, mounting a die thereon, forming electrical connections between the die and leads in the leadframe via ribbon bonding.

### Brief description of the several views of the drawings

One or more embodiments will now be described, by way of example only, with reference to the annexed figures, wherein:
Figure 1 is a plan view illustrative of the structure of a power semiconductor device,
Figure 2 is a cross-sectional view along line II-II of Figure 1,
Figure 3 and 4 are plan views illustrative of the structure of a power semiconductor device,
Figure 5 is illustrative of a ribbon according to embodiments of the present description represented against a conventional ribbon,
Figure 6 is illustrative of a manufacturing method of a ribbon as described in the present description,
Figure 7 is a plan view illustrative of ribbons as described in the present description mounted on a semiconductor device,
Figure 8 is a plan view illustrative of a possible further step in manufacturing a device as described herein,
Figure 9 is a cross-sectional view along line IX-IX of Figure 8.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

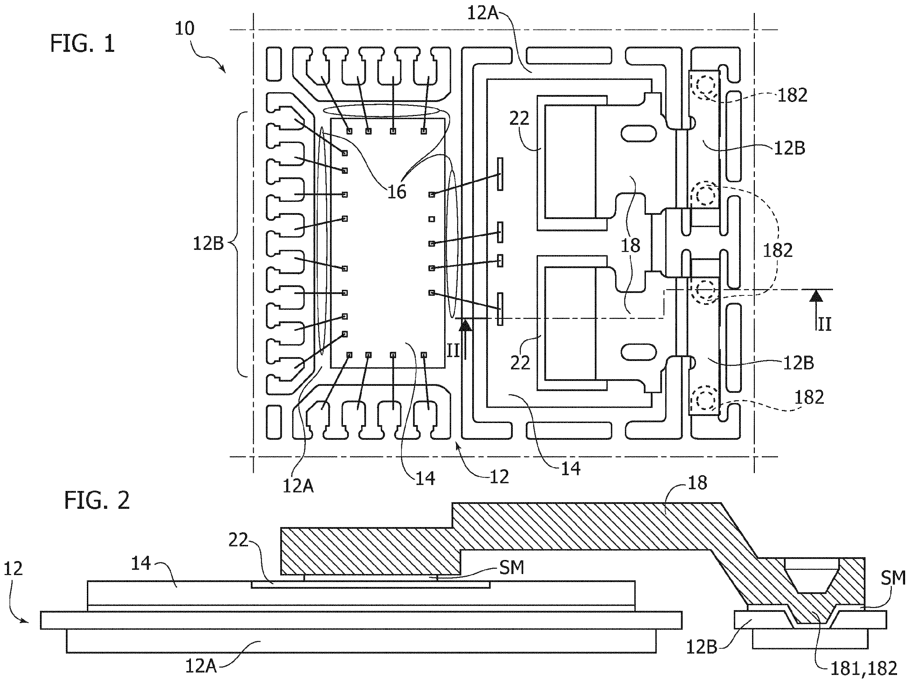

Figure 1 illustrates the structure of a power semiconductor device 10 comprising a low-power section (on the left-hand side of the Figure 1) e.g., a controller die or chip 14, attached on a first die pad 12A in a leadframe 12 and a high-power section (on the right-hand side of Figure 1) e.g., one or more power dice or chips 14 attached on one or more die pads 12A in the leadframe 12.

As used herein, the terms chip/s and die/dice are regarded as synonymous.

An array of leads 12B is arranged around the die pads 12A having the low-power and the high-power dice 14 mounted thereon.

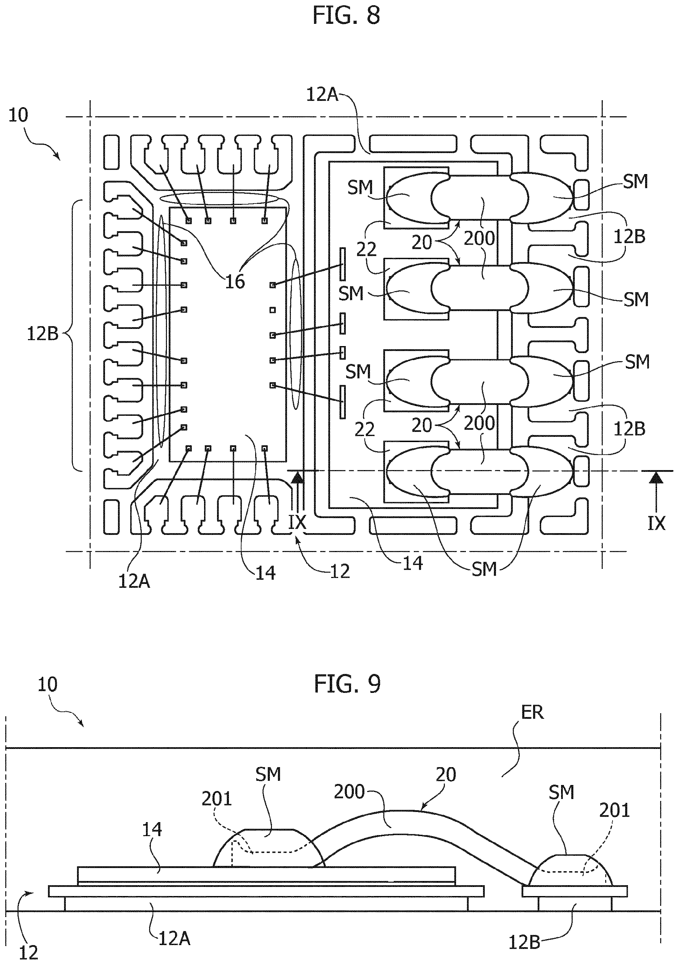

As illustrated herein by way of example, an integrated circuit semiconductor device such as the device 10 comprises, in addition to a substrate (leadframe) 12 having one or more semiconductor chips or dice 14 arranged thereon:
electrically conductive formations 16, 18 coupling the semiconductor chip(s) 14 to leads (outer pads) 12B in the substrate, and
an insulating encapsulation ER (e.g., an epoxy resin, whose outline is partly illustrated in dashed lines only in Figure 9 for simplicity) molded on the assembly thus formed to complete the plastic body of the device 10.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Essentially, a leadframe 12 comprises an array of electrically-conductive formations (or leads, e.g., 12B) that from an outline location extend inwardly in the direction of a semiconductor chip or die (e.g., 14) thus forming an array of electrically-conductive formations from a die pad (e.g., 12A) configured to have at least one (IC) semiconductor chip or die attached thereon. This may be via conventional means such as a die attach adhesive (a die attach film or DAF, for instance).

In certain cases, a leadframe can be of the pre-molded type, that is a type of leadframe comprising a sculptured metal (e.g., copper) structure formed by etching a metal sheet and comprising empty spaces that are filled by an insulating compound (a resin, for instance) "pre-molded" on the sculptured metal structure.

In current manufacturing processes of semiconductor devices, plural devices are manufactured concurrently to be separated into single individual device in a final singulation step. For simplicity and ease of explanation, the following description will refer to manufacturing a single device.

As noted, electrically conductive formations 16, 18 are provided coupling the semiconductor chip(s) 14 to leads (outer pads) 12B in the substrate.

In power semiconductor devices (e.g., the device 10 illustrated in Figure 1) the current transferred from the high-power section to the output pads 12B of the device can be significant. For that reason, providing electrical coupling (that is, electrically couple the power die 14 to the power leads 12B) to the high-power sector via a simple wire-bonding may be unsatisfactory and other methods are conventionally used.

For instance, as illustrated on the right-hand side of Figure 1, clips 18 are used for that purpose in the place of wires.

Wires 16 can still be used, as shown on the left-hand side of the figure, to provide electrical coupling to a low-power section (e.g., a controller) in the device.

That is, as illustrated in the figure, electrically conductive formations are provided comprising wire bonding patterns 16 coupling the low-power section (left-hand side of Figure 1) to selected ones of the leads 12B. These wire bonding patterns are coupled to die pads provided at the front or top surfaces of the chips (not visible in the figure).

Conversely, clips 18 (as illustrated in Figure 1) can be used to couple the high-power section (right-hand side of Figure 1) to selected ones of the leads 12B acting as (power) output pads of the device 10. Using clips in the place of wires takes into account the fact that the current transferred from the high-power section to the output pads in a power semiconductor device may be significant.

Figure 2 is a cross-sectional view along the line II-II of Figure 1 illustrative of a conventional approach for mounting clips 18 in a semiconductor device 10.

As illustrated, clips 18 are provided with pins 181 (provided via punching, for instance) at their terminal (distal) part (on the right-hand side of Figure 2) which will be coupled to respective leads 12B provided with recessed portions 182 at corresponding locations. Solder material SM may be used to form the electrical connection therebetween.

The proximal ends (on the left side in Figure 1) of the clips 18 can be soldered (via solder material, SM) to the bonding pads 22 located on the front/top surface of the chip 14.

The pins 181 and corresponding recessed portions 182 of the leads 12B in the leadframe 12 facilitate centering of the clip when mounting the clip 18 on the leadframe-chip assembly as well as keeping the clip in position during processing (e.g., during reflow).

As noted, when manufacturing small-sized power devices or when several electrical channels are involved, the method just described for providing electrical coupling to the power section of the device via clips may be faced with various difficulties.

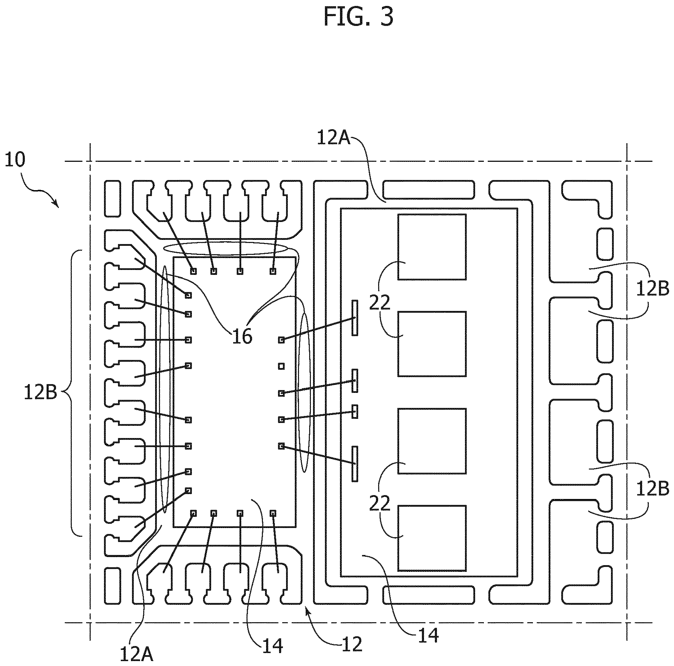

Figure 3 is illustrative of the structure of a (power) semiconductor device 10 having a power die 14 (on the right-hand side of the figure) with a larger number (four in the case exemplified in the figure) of die bonding pads 22 on the top/front surface of the die 14.

In such a case, providing electrical coupling between the die bonding pads 22 and the corresponding (power) leads 12B via clips as discussed in the foregoing may be difficult; in fact, as a consequence of the (relatively) smaller size of the clips, providing pins 181 by stamping or punching may be impractical and one has to renounce to the centering feature.

It is noted that, in case of small package devices, those problems may already appear when more than two channels (and thus more than two clips) are desired.

One possible approach to provide electrical coupling to the high-power section of a device as exemplified in Figure 3 is based on multiple-wire bonding.

As mentioned, due to the high current transferred from the high-power section of the device 10, a simple (single) wire bonding may prove to be inadequate. For that reason, in order to electrically couple one die pad 22 to one outer lead 12B, a plurality of wires (notionally of the same type of the wires 16 illustrated in Figure 3, for instance) may be used, arranged in a parallel configuration.

Such a solution would involve wedge-bonding a plurality of wires for each desired electrical coupling (thus, four couplings in the case exemplified in Figure 3), which may result in a disadvantageously long bonding process time.

Increasing the cross-section of the wires or using a different material with better electrical performance may possibly reduce the number of wires to be wedge-bonded, and thus possibly reduce bonding time, but will eventually involve undesirably higher production cost.

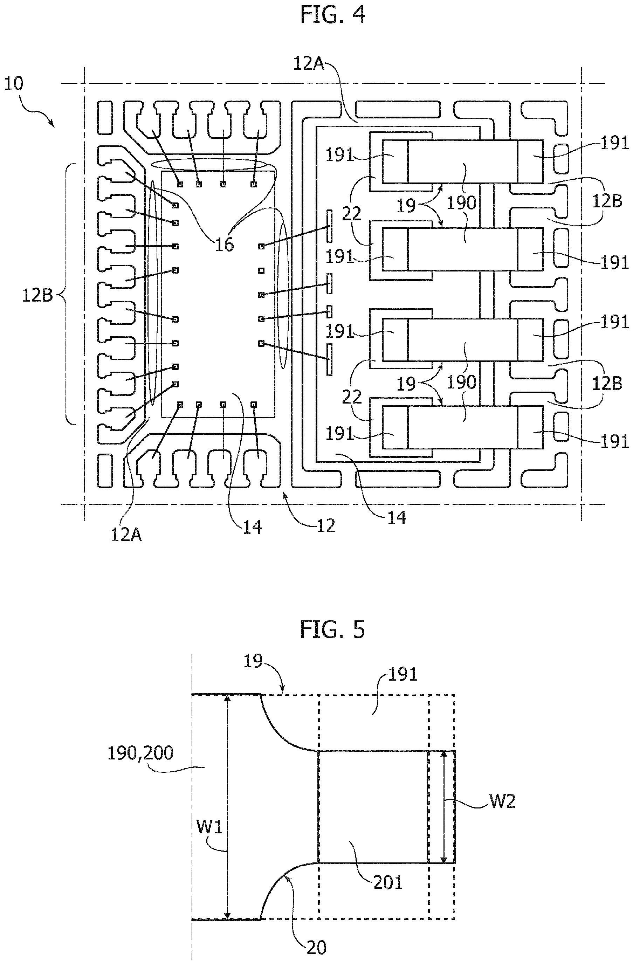

Figure 4 is illustrative of another conventional approach based on the use of ribbons 19 to provide electrical coupling to the high-power section of a device 10 as illustrated in Figure 3.

As illustrated in Figure 4, ribbons 19 are electrically conductive (e.g., of a metallic material such as copper or a copper alloy) strip-like formations comprising a central portion 190 and two opposed terminal parts 191 configured to contact the leads 12B and the die bonding pads 22 in order to provide electrical coupling therebetween.

The terminal parts 191 of the ribbons 19 may be bonded to the underlying die bonding pads 22 or leads 12B via ultrasonic wedge-bonding technique as known to those skilled in the art.

Ultrasonic wedge-bonding is essentially based on the application of ultrasound and (mechanical) pressure to form an electrical connection between the terminal part 191 of a ribbon and an underlying surface (of the die bonding pad 22 or the lead 12B).

While advantageous for certain aspects, wedge-bonding may have undesired effects on the device structure as a consequence of the mechanical stress applied during bond formation.

For instance, it is observed that ultrasonic wedge-bonding may cause cratering and/or cracking of the semiconductor material (e.g., silicon) of the die 14 beneath the die bonding pads 22 when forming the bond between die pads 22 and the terminal end of the ribbons 191.

Due to the mechanical stress applied, bond formation between leads 12B and ribbons 19 may also have detrimental effects on the leadframe 12; in certain cases, deformation and/or laceration of the leadframe 12 (especially in the proximity of the leads 12B) may cause the device under processing to be discarded, thus increasing overall manufacturing time and costs.

The parameters of the wedge-bonding process (e.g., ultrasound energy and mechanical pressure applied) may depend on the area of the surface to be bonded (the area of the portions 191, in the case exemplified in Figure 4) .

It is observed that a larger area generally results in more "stressful" parameters. On the other hand, a reduction of the width of the ribbons 19 (that is, a reduction of the width of the central portion 190 and the terminal portions 191) may have the undesired effect of reducing the conductivity of the ribbon 19, leading to poor electrical performance.

Such reduction in conductivity could be (at least notionally) counterbalanced by the use of a different (e.g., more conductive) material for the ribbons; this would however cause higher production costs.

To summarize, according to conventional approaches as discussed in the foregoing:
electrical coupling to the high-power section of (power) semiconductor device may be provided via clips 18, ribbons 19 or multiple wires;
such solutions may be unsatisfactory and/or involve higher costs/processing time when several (e.g., more than two) power electrical channels are desired.

Solutions as described herein aim at improving electrical coupling via ribbons with a modified design.

Solutions as described herein involve providing ribbons with a reduced area at (at least one of) the terminal portions configured to be connected to the leads or the die bonding pads.

Solutions as described herein may involve a modification of the wedge-bonding apparatus in order to provide ribbons according to embodiments of the present description.

In solutions as described herein ribbons modified according to the present description may be wedge-bonded applying less mechanical stress to the structure of the device.

In solutions as described herein solder material may be dispensed at the bonding regions of the ribbons to increase overall conductivity of the coupling thus improving the electrical performance of the coupling.

Figure 5 is illustrative of a detail of a ribbon 20 according to embodiments of the present description compared to a conventional ribbon 19.

In such a conventional ribbon 19, the terminal portions 191 (only one terminal portion is visible in the figure for simplicity) and the central portion 190 have a same width W1.

A ribbon 20 according to embodiments of the present description includes an (enlarged) central portion 200 with a first width (this may be the same width W1 of the whole conventional ribbon 19) and (one or two) tapered end portions 201 having a second width W2, smaller than the first width W1.

That is, electrically conductive ribbons 20 as proposed herein have:
substantially constant thickness (in the "vertical" direction, transverse to the plane of the substrate 12) at the first and second end portions 201 and at the body portion 200, and
different widths (W1, and W2, respectively) in the "horizontal" direction, parallel to the plane of the substrate 12.

As already mentioned, the parameters of the wedge-bonding process, and consequently the mechanical stress applied to the various parts of the device (e.g., the die 14 or the leads 12B) may depend on the area of the surface to be bonded in the sense that a larger area generally involves more "stressful" parameter.

In view of this fact, the terminal portion 201 of the ribbon 20 (that is, the portion of the ribbon configured to be wedge bonded) is advantageously shaped in such a way to reduce the area that is to be wedge-bonded (to the lead 12B or the die bonding pad 22). The area of the terminal portion 201 is thus reduced by reducing the width W2 of the terminal portion 201 (W2<W1).

It is noted that, once a reduced area is used at the terminal portion(s) 201 as illustrated in Figure 5, the relative shape may vary with respect to the simple, symmetrical tapering as illustrated.

It is noted that only the terminal portion of the ribbon 201 is reduced in size; the central portion 200 of the ribbon 20 may be advantageously maintained (e.g., width W1) in order to preserve satisfactory electrical performance.

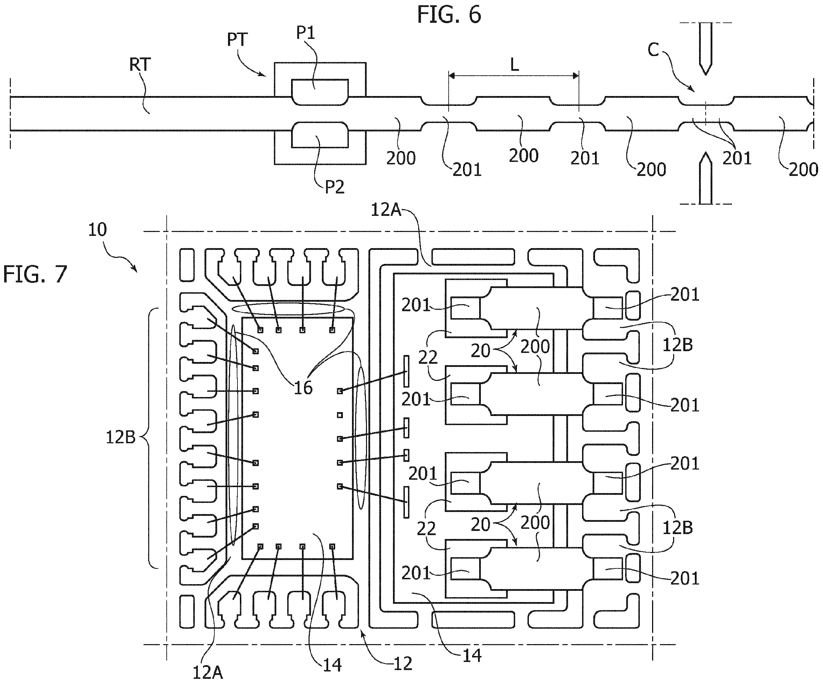

Figure 6 illustrates an apparatus which may be used to provide ribbons 20 with a terminal portion 201 of reduced area. Such an apparatus may be advantageously included in a (otherwise conventional) wedge-bonding apparatus; in this way no substantial additional processing steps are added to the manufacturing process.

As illustrated in Figure 6, a "raw" metal strip RT (of width W1, for instance) can be fed (from left to right in Figure 6) to a tool PT configured to perform a sort of hourglass shaping of the strip RT, thus forming therein an alternation of "wide" and "narrow" portions.

The tool PT may be implemented in different ways with different active members P1, P2 acting on the tape.

For instance, the members P1, P2 can comprise reciprocating punches P1, P2 acting on opposed sides of the strip RT to plastically deform the material of the strip RT by squeezing the strip RT therebetween at the desired narrowed portions.

Alternatively, the members P1, P2 can comprise blanking or milling heads P1, P2 acting at opposed sides of the strip RT to form therein cutouts at the desired narrowed portions.

These implementations facilitate providing electrically conductive ribbons 20 having a substantially constant thickness (in the "vertical" direction, transverse to the plane of the substrate 12) at the first and second end portions 201 and at the body portion 200.

This is in contrast to the different widths (W1, and W2, respectively) in the "horizontal" direction, parallel to the plane of the substrate 12.

To summarize, Figure 6 is illustrative of an apparatus that a may be used for producing a ribbon 20 as discussed herein, such apparatus comprising a cascaded arrangement of:
a shaping workstation PT (a punching or blanking/milling workstation, for instance) configured to receive the electrically conductive strip RT and form therein an alternation of wide portions having the first width W1 and narrow portions having the second width W2, and
a singulating workstation C (a cutting blade or saw, for instance) configured to receive the electrically conductive strip RT having formed therein the alternation of wide (width W1) and narrow (width W2) portions and sever that electrically conductive strip RT at the narrow portions of width W2 to produce individual electrically conductive ribbons 20 that comprise a body portion 200 with the first width W1 as well as first and second tapered end portions 201 with the second width W2 smaller than the first width W1 of the body portion 200.

Still other implementations can be devised (e.g., where the wide body portions 200 of a ribbon 20 result from squeezing a strip that is left unsqueezed where narrow end portions 201 are intended to be provided).

Whatever the implementation of the tool PT, the strip RT having formed therein an alternation of "wide" and "narrow" portions can be fed to a cutting station C (e.g., as used to produce conventional ribbons such as the ribbon 19 of Figure 5) to be cut into individual ribbons 20 of length L each comprising an enlarged body portion (of width W1, for instance) and two narrow end portions (of reduced width W2, for instance, less than W1).

The specific parameters describing a desired shape of the ribbons 20 (W1, W2 or the length L of the ribbons, for instance) depend on the design of the device where they are intended to be used. An apparatus as illustrated in Figure 6 can be easily adapted to those parameters.

It will be appreciated that an apparatus as illustrated in Figure 6 can be integrated in a simple and time/cost effective way into an otherwise conventional assembly flow where ribbons are used.

Figure 7 illustrates ribbons 20 mounted in a bridge-like position between a (power) semiconductor die 14 (e.g., contacting the die pads 22 on the front/top surface of the die 14) and the outer leads 12B to provide electrical coupling therebetween.

As illustrated in Figure 7, one terminal portion 201 (on the left-hand side of the ribbon 20) is wedge-bonded to a die bonding pad 22 on the top/front surface of the die 14 and the other terminal portion (still referenced with 201, on the right-hand side of the ribbon 20) is wedge-bonded to a lead 12B.

As a consequence of the reduced area of the portions that are bonded compared to a conventional ribbon (referenced as 19 in Figure 5) "gentler" bonding parameters (e.g., less ultrasound energy and/or less pressure) can be advantageously used thus reducing the risk to damage the leads 12B (e.g., laceration) and/or the die bonding pads 22 (e.g., cratering/cracking).

As already mentioned, the shape of the ribbons 20 as illustrated, for instance, in Figure 7 is merely exemplary.

In particular, the ribbons 20 have been illustrated having a symmetrical shape, that is having both terminal portions 201 of reduced area. This feature should not be construed in a limiting sense of the embodiments: just by way of example, depending on the particular design of the "final" device 10, ribbons 20 may be provided with only one terminal portion 201 of reduced area and/or have terminal portions 201 of reduced area provides both ends with an asymmetrical shape (e.g., by bestowing on the ribbons 20 a sort of lozenge shape).

In order to counter the possible (relatively small) reduction in conductivity due to the reduced contact area provided by the terminal portions of the ribbons 201, an optional further step may be added to the manufacturing process as discussed so far.

Figures 8 and 9 (wherein Figure 9 is a cross-sectional view along line IX-IX of Figure 8) are illustrative of such additional (and optional) step.

As illustrated, solder material SM may be dispensed at the narrow terminal portion(s) of the ribbons 201 (and the die bonding pads 22 or the leads 12B there beneath). It is noted that the solder material SM may be dispensed in such a way to extend beyond the terminal portion 201 of reduced area of the ribbons 20. The larger area provided by the (electrically conductive) solder material SM increases the conductivity as provided by the ribbons 20, thus improving the electrical performance thereof.

Moreover, as those skilled in the art may appreciate, dispensing solder material SM at the terminal portions 201 wedge-bonded to the die pads 22 or the leads 12B, may desirably "strengthen" the bonding thus reducing the risk of detachment of the ribbon from the die pad/lead.

Further (conventional) steps in semiconductor device manufacturing process may comprise:
a molding step, wherein a molding compound (such as an epoxy resin, for instance: see ER in Figure 9) is molded onto the assembly to form a protective plastic package of the device, and
a singulation step, wherein the plurality of devices concurrently processed so far is "singulated" into individual devices.

Without prejudice to the underlying principles, the details and embodiments may vary, even significantly, with respect to what has been described by way of example only without departing from the extent of protection. The extent of protection is determined by the annexed claims.

## Claims

1. A method, comprising:
arranging a semiconductor die (14) at a die mounting location (12A) of a substrate (12), the substrate (12) comprising an array of electrically conductive leads (12B) at the periphery of the substrate (12), and
electrically coupling the semiconductor die (14) and selected ones of the electrically conductive leads (12B) in the array of electrically conductive leads (12B) via electrically conductive ribbons (20) having a body portion (200) having a first width (W1) as well as first and second end portions (201) bonded to the semiconductor die (14) and to electrically conductive leads (12B) in the array of electrically conductive leads (12B), respectively,
wherein at least one of the first and second end portions (201) of the electrically conductive ribbons (20) comprises a tapered portion having a second width (W2) smaller than the first width (W1) of the body portion (200).

2. The method of claim 1, wherein the electrically conductive ribbons (20) have a substantially constant thickness at the first and second end portions (201) and at the body portion (200).

3. The method of claim 1 or claim 2, comprising dispensing electrically conductive material (SM) at said tapered portion having a second width (W2) smaller than the first width (W1) of the body portion (200) to provide a current conduction path of substantially constant cross-sectional area extending between said first and second end portions (201).

4. The method of any of the previous claims, comprising wedge-bonding said first and second end portions (201) to the semiconductor die (14) and to electrically conductive leads (12B) in the array of electrically conductive leads (12B).

5. An electrically conductive ribbon (20) for use in the method of any of claims 1 to 4, wherein the ribbon (20) comprises a body portion (200) having a first width (W1) as well as first and second end portions (201) configured to be bonded to a semiconductor die (14) and to electrically conductive leads (12B) in an array of electrically conductive leads (12B), respectively,
wherein at least one of the first and second end portions (201) of the electrically conductive ribbon (20) comprises a tapered portion having a second width (W2) smaller than the first width (W1) of the body portion (200).

6. The electrically conductive ribbon (20) of claim 5, wherein the ribbon (20) has a substantially constant thickness at the first and second end portions (201) and at the body portion (200).

7. Apparatus for producing a ribbon (20) according to claim 5 or claim 6, the apparatus comprising:
a shaping workstation (PT) configured to receive an electrically conductive strip (RT) and form therein an alternation of wide portions having a first width (W1) and narrow portions having a second width (W2) smaller than the first width (W1) of the body portion (200), and
a singulating workstation (C) configured to sever the electrically conductive strip (RT) at the narrow portions to produce individual electrically conductive ribbons (20) comprising a body portion (200) having said first width (W1) as well as first and second end portions (201) having said second width (W2) smaller than the first width (W1) of the body portion (200).

8. A device (10), comprising:
a semiconductor die (14) arranged at a die mounting location (12A) of a substrate (12), the substrate (12) comprising an array of electrically conductive leads (12B) at the periphery of the substrate (12), and
electrically conductive ribbons (20) electrically coupling the semiconductor die (14) and selected ones of the electrically conductive leads (12B) in the array of electrically conductive leads (12B), the electrically conductive ribbons (20) having a body portion (200) having a first width (W1) as well as first and second end portions (201) bonded to the semiconductor die (14) and to electrically conductive leads (12B) in the array of electrically conductive leads (12B), respectively,
wherein at least one of the first and second end portions (201) of the electrically conductive ribbons (20) comprises a tapered portion having a second width (W2) smaller than the first width (W1) of the body portion (200).

9. The device (10) of claim 8, wherein the electrically conductive ribbons (20):
have a substantially constant thickness at the first and second end portions (201) and at the body portion (200) and/or
are wedge-bonded at said first and second end portions (201) to the semiconductor die (14) and to electrically conductive leads (12B) in the array of electrically conductive leads (12B).

10. The device (10) of claim 8 or claim 9, comprising electrically conductive material (SM) dispensed at said tapered portion having a second width (W2) smaller than the first width (W1) of the body portion (200) to provide a current conduction path of substantially constant cross-sectional area extending between said first and second end portions (201).
